# EUROPEAN PATENT APPLICATION

(11) **EP 4 429 434 A1**
(43) Date of publication of application: **11.09.2024**
(21) Application number: 24159957.0
(22) Date of filing: 27.02.2024
(51) Int. Cl.: H10B 12/00

(54) **INTEGRATED CIRCUIT DEVICES AND METHODS OF MANUFACTURING THE SAME**

(30) Priority: 06.03.2023 KR 20230029273
(71) Applicant: Samsung Electronics Co., Ltd., Suwon-si, Gyeonggi-do 16677 (KR)
(72) Inventor: SONG, Suyoun, 16677 Suwon-si, Gyeonggi-do (KR); KANG, Yoongoo, 16677 Suwon-si, Gyeonggi-do (KR); PARK, Kyungwook, 16677 Suwon-si, Gyeonggi-do (KR); BAN, Youmin, 16677 Suwon-si, Gyeonggi-do (KR); SEO, Changwoo, 16677 Suwon-si, Gyeonggi-do (KR); SHIM, Hyunchul, 16677 Suwon-si, Gyeonggi-do (KR)
(74) Representative: Kuhnen & Wacker Patent- und Rechtsanwaltsbüro PartG mbB

(57) **Abstract**

An integrated circuit device includes a substrate having a plurality of active regions, a bit line extending in a horizontal direction on the substrate, an insulating capping pattern formed on the bit line and extending along the bit line, a direct contact disposed in a direct contact hole formed on the substrate and connected between a first active region selected from among the plurality of active regions and the bit line, and a spacer structure contacting a sidewall of the direct contact and a sidewall of the bit line The spacer structure includes a first spacer layer extending in a vertical direction on the sidewall of the direct contact and the sidewall of the bit line, and a second spacer layer covering at least a portion of the first spacer layer and extending in the vertical direction.

## Description

### BACKGROUND

The inventive concept relates to an integrated circuit device and a method of manufacturing the same, and more particularly, to an integrated circuit device including a bit line and a method of manufacturing the integrated circuit device.

According to the downscaling of integrated circuit devices, the size of individual microcircuit patterns to implement integrated circuit devices is being continually reduced. In addition, as integrated circuit devices are highly integrated, a line width of bit lines becomes smaller and the difficulty of a process for forming a contact between bit lines is increased. In particular, in order to achieve a reduced bit line width according to device shrinkage in some devices, the thickness of a spacer needs to be lowered. However, when this spacer thickness is lowered below a certain amount, undesirable oxidation can occur in the deposition and cleaning steps that occur in connection with the spacer. Thus, it would be helpful to develop a spacer that helps avoid this issue.

### SUMMARY

Aspects of the inventive concept provide an integrated circuit device including a first spacer layer and a second spacer layer each including a low dielectric material.

Aspects of the inventive concept provide an integrated circuit device including only a first spacer layer on a lower end of a direct contact and an inner wall of a direct contact hole.

According to an aspect of the inventive concept, an integrated circuit device includes a substrate having a plurality of active regions, a bit line extending in a first horizontal direction on the substrate, an insulating capping pattern formed on the bit line and extending along the bit line, a direct contact disposed in a direct contact hole formed on the substrate and connected between a first active region selected from among the plurality of active regions and the bit line, and a spacer structure contacting a sidewall of the direct contact and a sidewall of the bit line. The spacer structure includes a first spacer layer extending in a vertical direction on the sidewall of the direct contact and the sidewall of the bit line and a second spacer layer covering at least a portion of the first spacer layer and extending in the vertical direction.

According to another aspect of the inventive concept, an integrated circuit device includes a substrate having a plurality of active regions, a plurality of bit lines spaced apart from each other in a first horizontal direction on the substrate and extending in a second horizontal direction crossing the first horizontal direction, insulating capping patterns each disposed on a respective bit line of the plurality of bit lines to overlap the respective bit line in a vertical direction, a direct contact disposed in a direct contact hole formed on the substrate and connected directly between a first active region selected from among the plurality of active regions and a first bit line selected from among the plurality of bit lines, a contact plug connected to a second active region adjacent to the first active region among the plurality of active regions and extending in the vertical direction on the substrate, and a spacer structure contacting a sidewall of the direct contact and a sidewall of the bit line. The spacer structure includes a first spacer layer extending in the vertical direction on the sidewall of the direct contact and the sidewall of the bit line and extending to an inner wall of the direct contact hole and a second spacer layer covering at least a portion of the first spacer layer and extending in the vertical direction.

According to another aspect of the inventive concept, a method of manufacturing an integrated circuit device includes forming, on a substrate having a plurality of active regions, a bit line, a direct contact hole, and a direct contact connected to a first active region selected from among the plurality of active regions within the direct contact hole, forming a first spacer layer covering a sidewall of the bit lines, a sidewall of the direct contacts, and inner walls of the direct contact hole, forming a first oxide film layer and a buried insulating layer on the first spacer layer to overlap a lower sidewall of the direct contact and an inner wall of the direct contact hole, and forming a second spacer layer on the first spacer layer to horizontally overlap a portion of the sidewall of the bit line and a portion of the sidewall of the direct contact.

### BRIEF DESCRIPTION OF THE DRAWINGS

Embodiments will be more clearly understood from the following detailed description taken in conjunction with the accompanying drawings in which:
FIG. 1 is a layout diagram showing a schematic configuration of an integrated circuit device according to an embodiment;
FIG. 2 is a plan layout diagram schematically illustrating a portion of the memory cell array area of FIG. 1;
FIG. 3 is a cross-sectional view taken along line A-A' of FIG. 2;
FIGS. 4 to 18 are cross-sectional views taken along line A-A' of FIG. 2 illustrating a method of manufacturing an integrated circuit device, according to an embodiment.

### DETAILED DESCRIPTION OF THE EMBODIMENTS

Hereinafter, embodiments of the inventive concept will be described in detail with reference to the accompanying drawings. Like reference numerals are used for the same components in the drawings, and descriptions thereof are omitted.

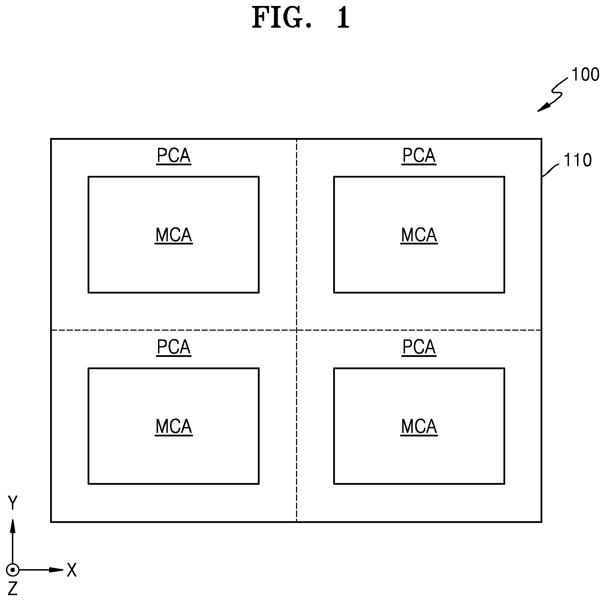

FIG. 1 is a layout diagram showing a schematic configuration of an integrated circuit device 100 according to an embodiment.

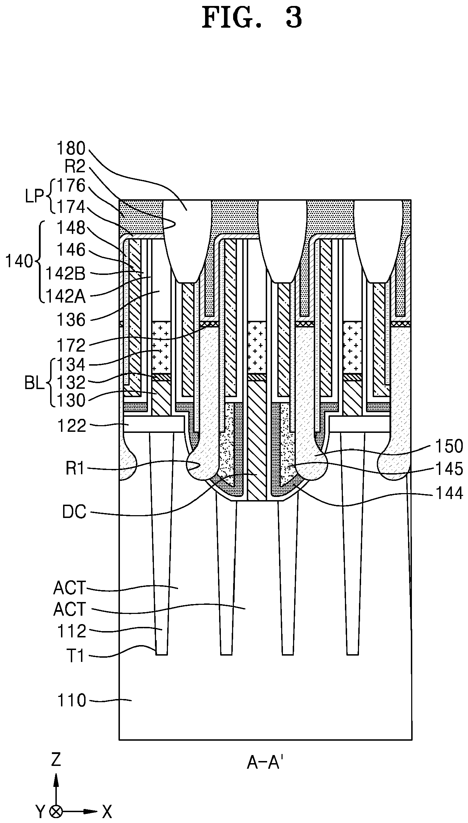

Referring to FIG. 1, the integrated circuit device 100 may include a substrate 110 (refer to FIG. 3) including a cell array area MCA and a peripheral circuit area PCA. The cell array area MCA may be a memory cell area of a DRAM device, and the peripheral circuit area PCA may be a core area or a peripheral circuit area of the DRAM device. For example, the cell array area MCA may include cell transistors and capacitor structures connected the cell transistors, and the peripheral circuit area PCA may include peripheral circuit transistors for transmitting signals and/or power to the cell transistors included in the cell array area MCA. In some embodiments, the peripheral circuit transistors may configure various circuits such as a command decoder, a control logic, an address buffer, a row decoder, a column decoder, a sense amplifier, a data input/output circuit, etc. The integrated circuit device 100 may be, for example, a semiconductor memory chip formed on a semiconductor die.

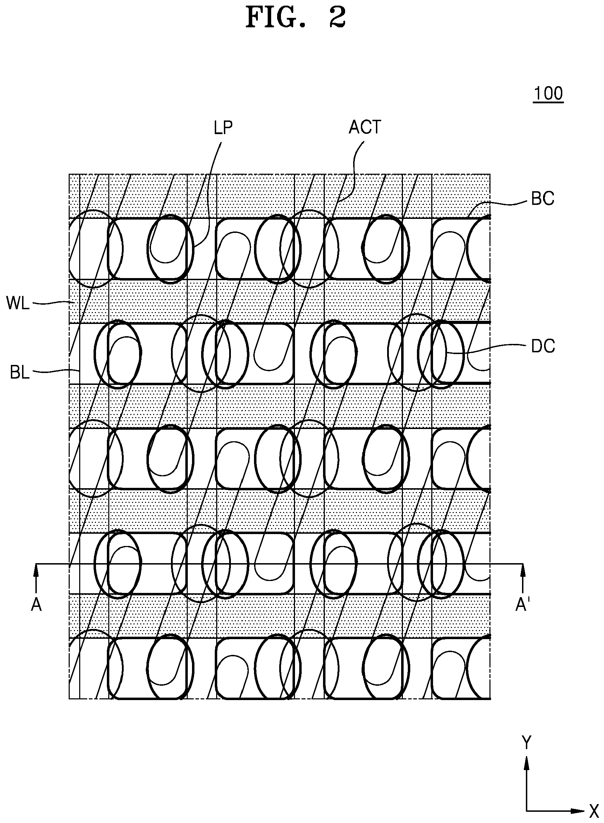

FIG. 2 is a plan layout diagram schematically illustrating a portion of the (memory) cell array area MCA of FIG. 1.

Referring to FIG. 2, the integrated circuit device 100 may include a plurality of active regions ACT. The plurality of active regions ACT may be disposed in an oblique direction with respect to a first horizontal direction (X direction) and a second horizontal direction (Y direction).

A plurality of word lines WL may extend parallel to each other in the first horizontal direction (X direction) across the plurality of active regions ACT. A plurality of bit lines BL may extend parallel to each other in the second horizontal direction (Y direction) crossing the first horizontal direction (X direction) on the plurality of word lines WL. The plurality of bit lines BL may be connected to the plurality of active regions ACT through direct contacts DC.

A plurality of buried contacts BC may be formed between two adjacent bit lines BL among the plurality of bit lines BL. In some embodiments, the plurality of buried contacts BC may be arranged in a line in the first horizontal direction (X direction) and the second horizontal direction (Y direction). A plurality of conductive landing pads LP may be formed on the plurality of buried contacts BC. The plurality of buried contacts BC and the plurality of conductive landing pads LP may serve to connect a lower electrode (not shown) of a capacitor formed on the plurality of bit lines BL to the active region ACT. At least a portion of each of the plurality of conductive landing pads LP may vertically overlap the buried contact BC.

FIG. 3 is a cross-sectional view taken along line A-A' of FIG. 2.

Referring to FIG. 3, the integrated circuit device 100 may include a substrate 110 in which a plurality of active regions ACT are defined by a device isolation layer 112. The device isolation layer 112 may be formed in a device isolation trench T1 formed in the substrate 110.

The substrate 110 may include or be formed of silicon, for example monocrystalline silicon, polycrystalline silicon, or amorphous silicon. In some embodiments, the substrate 110 may include or be formed of at least one selected from Ge, SiGe, SiC, GaAs, InAs, and InP. In some embodiments, the substrate 110 may include conductive regions, for example, a well doped with an impurity or a structure doped with an impurity. The device isolation layer 112 may include or be an oxide layer, a nitride layer, or a combination thereof.

A buffer layer 122 may be formed on the substrate 110. The buffer layer 122 may be formed to cover upper surfaces of the plurality of active regions ACT and an upper surface of the device isolation layer 112. The buffer layer 122 may include or be formed of, but is not limited to, a first silicon oxide film, a silicon nitride film, and a second silicon oxide film that are sequentially formed on the substrate 110.

A plurality of bit lines BL extending parallel to each other in the second horizontal direction (Y direction) may be formed on the buffer layer 122. The plurality of bit lines BL are spaced apart from each other in the first horizontal direction (X direction).

A plurality of direct contact holes DCH may be formed on the substrate 110, and a plurality of direct contacts DC may be formed in the direct contact holes DCH. The plurality of direct contacts DC may be formed on a portion of each of the plurality of active regions ACT. The plurality of direct contacts DC may be connected to the active regions ACT. Each of the plurality of bit lines BL may be connected to the active region ACT through a direct contact DC. The plurality of direct contacts DC may include or be formed of doped polysilicon. For example, the plurality of direct contacts DC may include or be formed of polysilicon including an n-type impurity such as phosphorus (P), arsenic (As), bismuth (Bi), and antimony (Sb) at a relatively high concentration.

Each of the plurality of bit lines BL may include a lower conductive layer 130, a middle conductive layer 132, and an upper conductive layer 134 sequentially formed on the substrate 110. Each of the plurality of bit lines BL may be covered with an insulating capping pattern 136. In a vertical direction (Z direction), the insulating capping pattern 136 may be disposed on the upper conductive layer 134. An upper surface of the lower conductive layer 130 of the bit line BL and an upper surface of the direct contact DC may be disposed on the same plane. In FIG. 3, it is illustrated that the plurality of bit lines BL have a triple conductive layer structure including the lower conductive layer 130, the middle conductive layer 132, and the upper conductive layer 134, but the present inventive concept is not limited thereto. For example, the plurality of bit lines BL may be formed as a stack structure of a plurality of conductive layers of a single conductive layer, a double conductive layer, or a quadruple conductive layer.

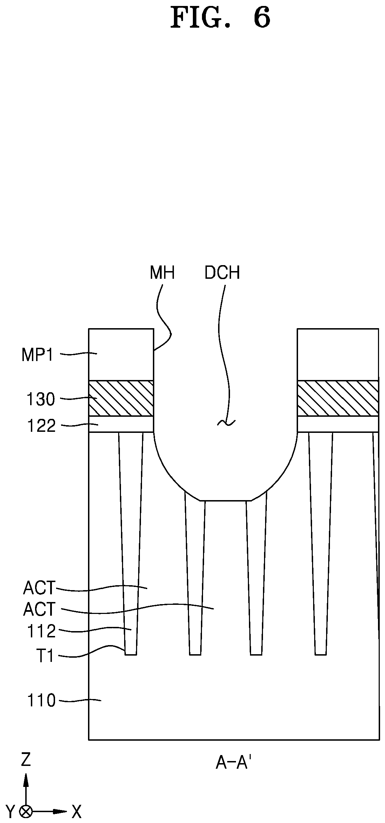

In some embodiments, the lower conductive layer 130 may include or be formed of a doped polysilicon layer. The middle conductive layer 132 and the upper conductive layer 134 may each include or be formed of a film including Ti, TiN, TiSiN, tungsten (W), WN, tungsten silicide (WSix), tungsten silicon nitride (WSixNy), ruthenium (Ru), or a combination thereof, respectively. For example, the middle conductive layer 132 may be a TiN film and/or a TiSiN film, and the upper conductive layer 134 may be a film including Ti, TiN, W, WN, WSixNy, Ru, or a combination thereof. As can be seen in FIG. 3 (see also, FIGS. 6, 7, and 9), the bit lines may be missing the lower conductive layer 130 where the direct contacts DC are formed. Accordingly, the direct contacts DC may contact both the active region ACT and the middle conductive layer 132 of the bit lines BL. The term "contact," "contacting," "contacts," or "in contact with," as used in the verb form herein, refers to a direct connection (i.e., touching) unless the context clearly indicates otherwise. Also, it will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the verb "contact"), there are no intervening elements present at the point of contact.

Each of the plurality of bit lines BL may be covered with the insulating capping pattern 136. The plurality of insulating capping patterns 136 may extend in the second horizontal direction Y on the plurality of bit lines BL. In this case, the insulating capping patterns 136 (each of which may individually be described as an insulating cap structure) may include a silicon nitride film.

A spacer structure 140 may be disposed on both (e.g., opposite) sidewalls of each of the plurality of bit lines BL. The spacer structure 140 may extend in the second horizontal direction Y on both sidewalls of the plurality of bit lines BL, and a portion of the spacer structure 140 may extend to an inside of the direct contact hole DCH to cover both sidewalls of the contact DC.

In some embodiments, the spacer structure 140 may include a first spacer layer 142A, a second spacer layer 142B, a second oxide film layer 146 and an outer spacer layer 148. The second spacer layer 142B, the second oxide film layer 146, and the outer spacer layer 148 may be sequentially disposed on the first spacer layer 142A. In some embodiments, the first spacer layer 142A and the second spacer layer 142B may include or be a low-dielectric material. The second oxide film layer 146 may include or be silicon oxide, and the outer spacer layer 148 may include or be silicon nitride.

The first spacer layer 142A may be conformally disposed on sidewalls of the plurality of bit lines BL, a sidewall of the insulating capping pattern 136, a sidewall of the direct contact DC, and inner walls of the direct contact hole DCH. The first spacer layer 142A may be deposited to a thickness of less than 10 Å. The first spacer layer 142A may include a low-k material. For example, the first spacer layer 142A may include a layer including h-BN, SiOCN, SiON, SiOC, SiCN, SiC, SiBN, Si₃N₄, a-BN, or a combination thereof. For example, h-BN may be a material having a low permittivity (k) of 3.3 and high electrical characteristics. In addition, h-BN or the like may be a material having high thermal stability and chemical stability. A low-k material may have a dielectric constant the same as or lower than silicon dioxide (e.g., about 3.9 or lower).

The first spacer layer 142A may protect the bit lines BL during a process such as melting laser annealing (MLA). Specifically, the first spacer layer 142A may prevent oxidation of the upper conductive layer 134 of the bit line BL from the second oxide film layer 146 or a first oxide film layer 144.

The second spacer layer 142B may be conformally disposed on the first spacer layer 142A. The second spacer layer 142B may be disposed on the first spacer layer 142A to overlap a portion of the sidewall of the plurality of bit lines BL, a portion of the sidewall of the direct contact DC, and a sidewall of the insulating capping pattern 136. The second spacer layer 142B may be disposed on the first spacer layer 142A to overlap a portion of the lower conductive layer 130, the middle conductive layer 132, and the upper conductive layer 134 among the plurality of bit lines BL.

The integrated circuit device 100 according to an embodiment may include the first spacer layer 142A without the second spacer layer 142B on a lower portion of the direct contact DC and an inner wall of the direct contact hole DCH. The second spacer layer 142B may be disposed on the first spacer layer 142A to overlap a portion of the sidewall of the direct contact DC. Specifically, the second spacer layer 142B may be disposed on an upper portion of the direct contact DC, and may not be disposed on a lower portion of the direct contact DC or on the inner wall of the direct contact hole DCH. The spacer structure 140 that overlaps an upper end of the direct contact DC and the bit line BL may include the first spacer layer 142A and the second spacer layer 142B. The spacer structure 140 that overlaps the lower portion of the direct contact DC and the direct contact hole DCH may include the first spacer layer 142A and not the second spacer layer 142B. As a result, the thickness of the spacer structure 140 that overlaps the upper portion of the direct contact DC and the bit line BL may be greater than a thickness of the spacer structure 140 that overlaps the lower portion of the direct contact DC and the direct contact hole DCH.

The second spacer layer 142B may be deposited to a thickness of less than 10 Å. The second spacer layer 142B may include a low-k material. For example, the second spacer layer 142B may include or be a layer formed of h-BN, SiOCN, SiON, SiOC, SiCN, SiC, SiBN, Si₃N₄, a-BN, or a combination thereof. In this case, the materials included in the first spacer layer 141A and the second spacer layer 142B may be the same, but are not limited thereto and may include different materials from each other.

The second spacer layer 142B may serve as a barrier to protect the first spacer layer 142A from being oxidized by the second oxide film layer 146. In addition, the second spacer layer 142B may prevent oxidation of the upper conductive layer 134 of the bit line BL during a manufacturing process.

The second oxide film layer 146 may be conformally disposed on the second spacer layer 142B. The second oxide film layer 146 may be disposed on the second spacer layer 142B to overlap a portion of the sidewall of the plurality of bit lines BL, a portion of the sidewall of the direct contact DC, and a sidewall of the insulating capping pattern 136. The second oxide film layer 146 may be disposed on the second spacer layer 142B to overlap a sidewall of a portion of the lower conductive layer 130, the middle conductive layer 132, and the upper conductive layer 134 among the plurality of bit lines BL. In this case, the second oxide film layer 146 may be or may include silicon oxide.

The outer spacer layer 148 may be conformally disposed on the second oxide film layer 146. The outer spacer layer 148 may be disposed on the second oxide film layer 146 or a first oxide film layer 144 to overlap a portion of the sidewall of the plurality of bit lines BL, a portion of the sidewall of the direct contact DC, a sidewall of the insulating capping pattern 136, and a portion of the inner wall of the direct contact hole DCH. In this case, the outer spacer layer 148 may include or be silicon nitride.

The first oxide film layer 144 may be disposed horizontally between a lower end of a contact plug 150 and the direct contact DC. The first oxide film layer 144 may cover a lower sidewall of the contact plug 150. The first oxide film layer 144 may cover the first spacer layer 142A to overlap an surface of the direct contact DC or direct contact hole DCH. A sidewall and a bottom surface of the first oxide film layer 144 may be surrounded by the first spacer layer 142A. In one embodiment, the first oxide film layer 144 may be or include silicon oxide.

The first spacer layer 142A, the second spacer layer 142B, the second oxide film layer 146, and the outer spacer layer 148 may extend parallel to the bit lines BL in the second horizontal direction (Y direction), respectively.

A buried insulating layer 145 may overlap a lower sidewall of the direct contact DC on the first oxide film layer 144 and fill a remaining space of the direct contact hole DCH. The buried insulating layer 145 may be surrounded by the first oxide film layer 144, the outer spacer layer 148, and the contact plug 150. The buried insulating layer 145 may include or be silicon nitride, silicon oxynitride, silicon oxide, or a combination thereof.

According to an embodiment, the spacer structure 140 of the integrated circuit device 100 may include a low-dielectric layer material layer having a two-layer structure. Because the spacer structure 140 includes the first spacer layer 142A and the second spacer layer 142B, there is an effect of preventing oxidation of the upper conductive layer 134. In addition, because the first spacer layer 142A and the second spacer layer 142B include a low-dielectric material, capacitance of the bit line BL may be reduced.

The direct contact DC is formed in the direct contact hole DCH formed in the substrate 110 and may extend to a level higher than an upper surface of the substrate 110. For example, the upper surface of the direct contact DC may be disposed at the same level as the upper surface of the lower conductive layer 130, and the upper surface of the direct contact DC may contact the lower surface of the middle conductive layer 132. Also, the lower surface of the direct contact DC may be disposed at a lower level than the upper surface of the substrate 110.

The plurality of contact plugs 150 may be disposed on the substrate 110. The plurality of contact plugs 150 may have a columnar shape extending in the vertical direction (Z direction) in a space between each of the plurality of bit lines BL (e.g., between adjacent bit lines BL of the plurality of bit lines BL). The contact plugs 150 may each extend in the vertical direction (Z direction) from a recess space R1 formed in the substrate 110. Each of the plurality of contact plugs 150 may contact the active region ACT.

A lower end of each of the plurality of contact plugs 150 may be disposed at a level lower than the upper surface of the substrate 110 to be buried in the substrate 110. The plurality of contact plugs 150 may constitute the plurality of buried contacts BC illustrated in FIG. 1. The plurality of contact plugs 150 may include doped polysilicon, metal, metal silicide, conductive metal nitride, or a combination thereof, but is not limited thereto. Each contact plug 150 may have a bulb and stem shape, where the bottom portion of the plug has a bulging or protruding curved shape, and the sidewalls above the bottom portion are vertical and parallel to each other, as viewed from the Y direction.

A plurality of contact plugs 150 may be arranged in a line in the second horizontal direction (Y direction) between a pair of bit lines BL selected from among a plurality of bit lines BL and adjacent to each other. An insulating fence may be disposed between each of the plurality of contact plugs 150 arranged in a row in the second horizontal direction (Y direction). The plurality of contact plugs 150 may be insulated from each other by the plurality of insulating fences. Each of the plurality of insulating fences may have a pillar shape extending in the vertical direction (Z direction) on the substrate 110. In some embodiments, the plurality of insulating fences may include or be formed of silicon nitride.

In the integrated circuit device 100, one direct contact DC and a pair of contact plugs 150 facing each other with the one direct contact DC therebetween may be connected to different active regions ACT among the plurality of active regions ACT.

A metal silicide layer 172 and a plurality of conductive landing pads LP may be sequentially formed on each of the plurality of contact plugs 150. The plurality of conductive landing pads LP may be connected to the plurality of contact plugs 150 through the metal silicide layer 172. The plurality of conductive landing pads LP may extend from a space between each of the plurality of insulating capping patterns 136 to an upper part of each of the plurality of insulating capping patterns 136 to vertically overlap a portion of the plurality of bit lines BL. Each of the plurality of conductive landing pads LP may include a conductive barrier film 174 and a conductive layer 176.

In some embodiments, the metal silicide layer 172 may be or may include cobalt silicide, nickel silicide, or manganese silicide, but is not limited to the above examples. In some embodiments, the metal silicide layer 172 may be omitted. The conductive barrier film 174 may have a Ti/TiN stack structure. The conductive layer 176 may include be formed of doped polysilicon, metal, metal silicide, conductive metal nitride, or a combination thereof. For example, the conductive layer 176 may be tungsten (W). The plurality of conductive landing pads LP may have a plurality of island-pattern shapes when viewed from a plan view. The plurality of conductive landing pads LP may be electrically insulated from each other by an insulating film 180 that fills a space around the plurality of conductive landing pads LP.

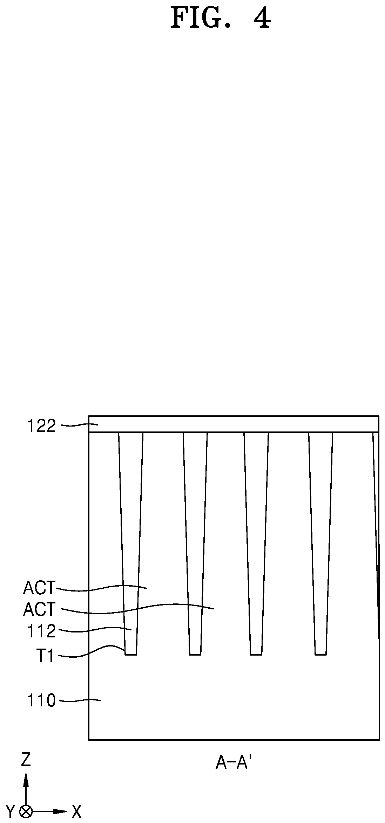

FIGS. 4 to 18 are cross-sectional views taken along line A-A' of FIG. 2 illustrating a method of manufacturing the integrated circuit device 100 according to an embodiment.

FIGS. 4 to 18 are cross-sectional views illustrating a method of manufacturing the integrated circuit device 100 according to a process sequence, according to an embodiment. FIGS. 4 to 17 are cross-sectional views of some components according to the process sequence of a partial area corresponding to the line A-A' of FIG. 2. The method of manufacturing the integrated circuit device 100 illustrated in FIG. 3 is described with reference to FIGS. 4 to 17.

Referring to FIG. 4, a device isolation trench T1 is formed on a substrate 110, and a device isolation layer 112 is formed in the device isolation trench T1. A plurality of active regions ACT are defined on the substrate 110 by the device isolation layer 112. An ion implantation process may be performed to form a plurality of source/drain regions on the plurality of active regions ACT.

A buffer layer 122 is formed on the substrate 110. The buffer layer 122 may be formed to cover upper surfaces of the plurality of active regions ACT and upper surfaces of the device isolation layer 112. The buffer layer 122 may be a first silicon oxide film, a silicon nitride film, and a second silicon oxide film sequentially formed on the substrate 110.

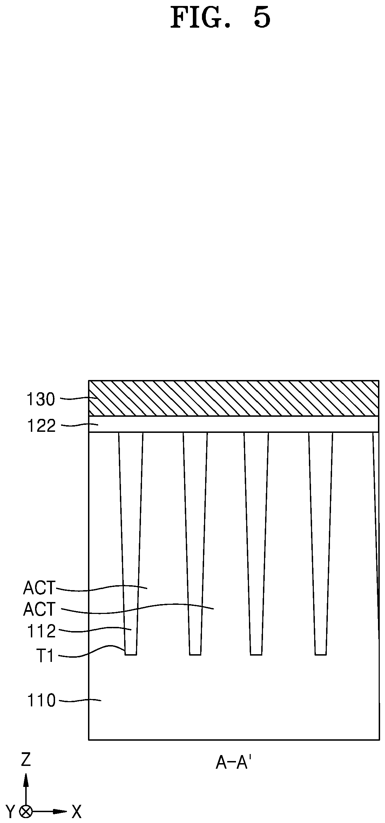

Referring to FIG. 5, a lower conductive layer 130 is formed on the buffer layer 122. The lower conductive layer 130 may be a doped polysilicon layer.

Referring to FIG. 6, after forming a mask pattern MP1 on the lower conductive layer 130, a direct contact hole DCH exposing the active region ACT of the substrate 110 is formed by etching portions of each of the lower conductive layer 130 exposed through an opening MH of the mask pattern MP1 and the buffer layer 122, the substrate 110, and the device isolation layer 112 under the lower conductive layer 130. The mask pattern MP1 may be or include an oxide film, a nitride film, or a combination thereof, but is not limited thereto.

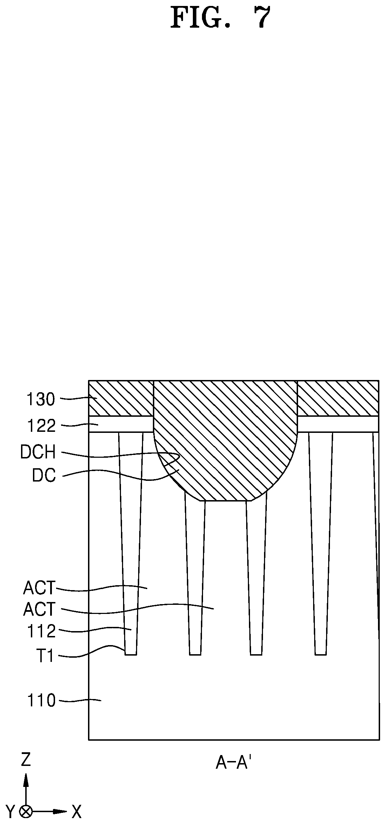

Referring to FIG. 7, the mask pattern MP1 is removed from a resultant product of FIG. 6, and a direct contact DC is formed in the direct contact hole DCH.

In one embodiment, to form the direct contact DC, a doped polysilicon film having a thickness sufficient to fill the direct contact hole DCH is formed on an inside of the direct contact hole DCH and on a lower conductive layer 130, and an unnecessary portion of the doped polysilicon layer may be removed so that the doped polysilicon layer remains only within the direct contact hole DCH.

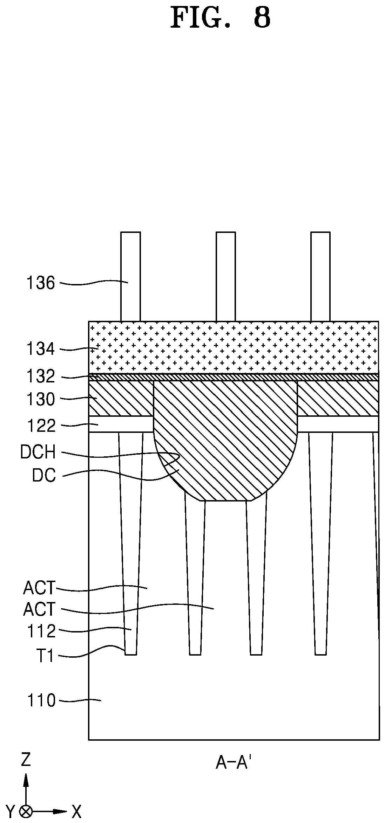

Referring to FIG. 8, a middle conductive layer 132, an upper conductive layer 134, and a plurality of insulating capping patterns 136 are sequentially formed on the lower conductive layer 130 and the direct contact DC. Each of the plurality of insulating capping patterns 136 may be formed as a line pattern extending in a second horizontal direction (Y direction).

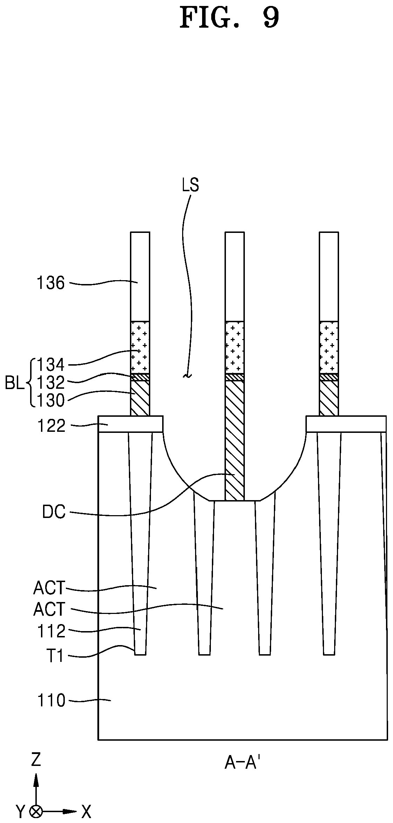

Referring to FIG. 9, a plurality of bit lines BL may be formed on the substrate 110 by etching portions of each of the upper conductive layer 134, the middle conductive layer 132, the lower conductive layer 130, and the direct contact DC using the insulating capping pattern 136 as an etch mask. The plurality of bit lines BL may include remaining portions of each of the lower conductive layer 130, the middle conductive layer 132, and the upper conductive layer 134. After the plurality of bit lines BL are formed, a portion of the direct contact hole DCH around the direct contact DC may be exposed again, and a line space LS elongated in the second horizontal direction (Y direction) may be defined between each of the bit line structures each including the bit line BL and the insulating capping pattern 136.

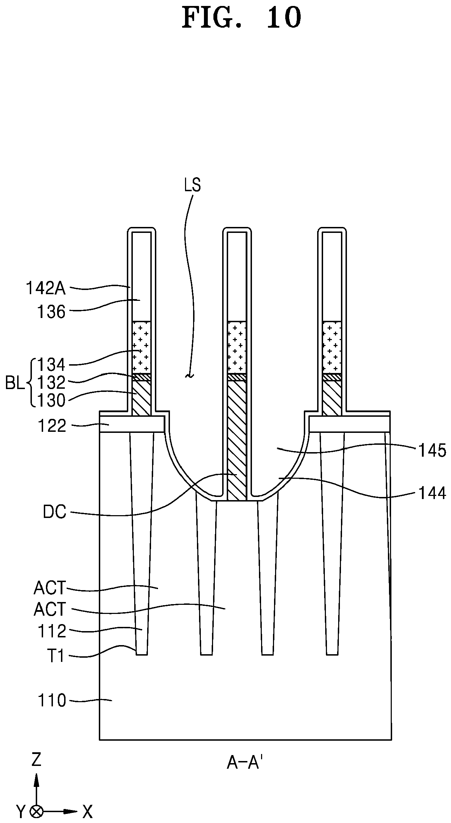

Referring to FIG. 10, a first spacer layer 142A conformally covering an exposed surface of a resultant product of FIG. 9 is formed. The first spacer layer 142A may be conformally formed to cover a sidewall of the plurality of bit lines BL, a sidewall of the insulating capping pattern 136, a sidewall of the direct contact DC, and inner walls of the direct contact hole DCH. The first spacer layer 142A may be continuously and evenly deposited to a thickness of less than 10 Å. In some embodiments, the first spacer layer 142A may be continuously deposited to a thickness of between 5Å and 10Å, though other thicknesses less than 10Å may be used. In some embodiments, the first spacer layer 142A may be deposited by using a metal organic chemical vapor deposition (MOCVD) method, a metal organic vapor phase epitaxy (MOVPE) method, a chemical vapor deposition (CVD) method, a low pressure chemical vapor deposition (LPCVD) method, an atomic layer deposition (ALD) method, an ion beam sputter deposition (IBSD) method, a molecular-beam epitaxy (MBE) method, a plasma assisted-molecular beam epitaxy (PA-MBE) method, etc.

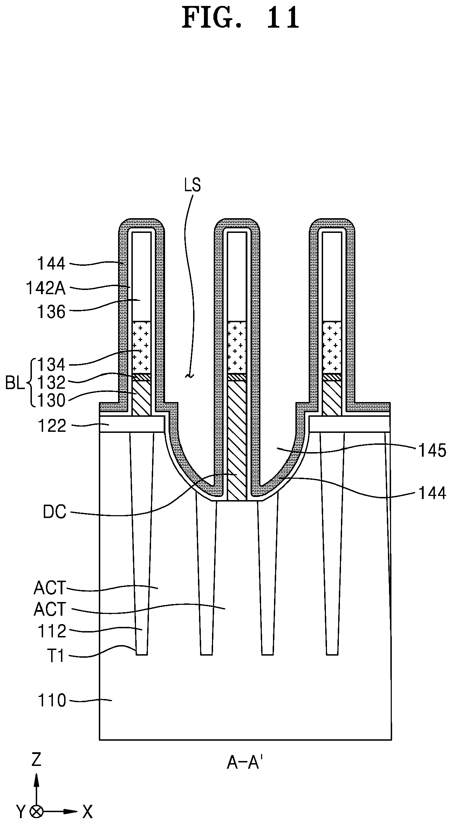

Referring to FIG. 11, a first oxide film layer 144 conformally covering an exposed surface of a resultant product of FIG. 10 is formed. The first oxide film layer 144 may be formed on the first spacer layer 142A by being spaced apart from the sidewalls of the plurality of bit lines BL, the sidewall of the insulating capping pattern 136, the sidewall of the direct contact DC, and the inner wall of the direct contact hole DCH. In order to form the first oxide film layer 144, a CVD process or an ALD process may be used.

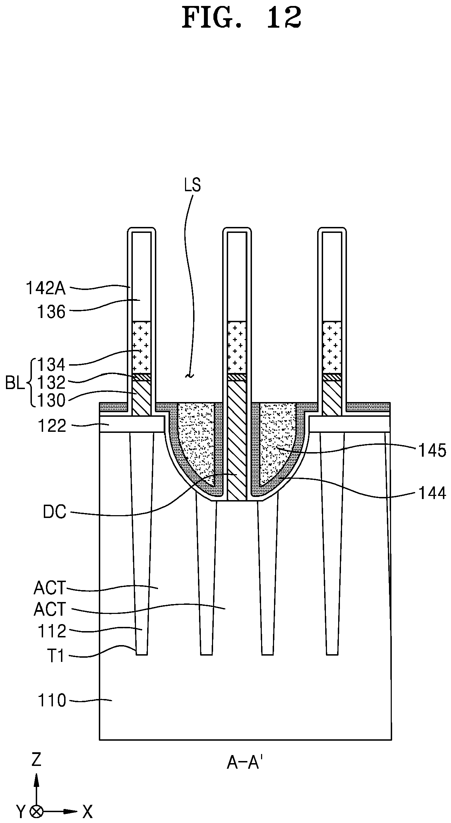

Referring to FIG. 12, in a resultant product of FIG. 11, a buried insulating layer 145 that overlaps the lower sidewall of the direct contact DC and the inner wall of the direct contact hole DCH and fills a remaining space of the direct contact hole DCH is formed on the first oxide film layer 144. In the resultant product of FIG. 11, the buried insulating layer 145 may be formed on the exposed first oxide film layer 144, and a portion of an upper portion of the first oxide film layer 144 and a portion of an upper portion of the buried insulating layer 145 may be removed, for example, by a strip process.

The buried insulating layer 145 may include a portion filling the inside of the direct contact hole DCH and a portion covering an inlet of the direct contact hole DCH from the outside of an inlet side of the direct contact hole DCH.

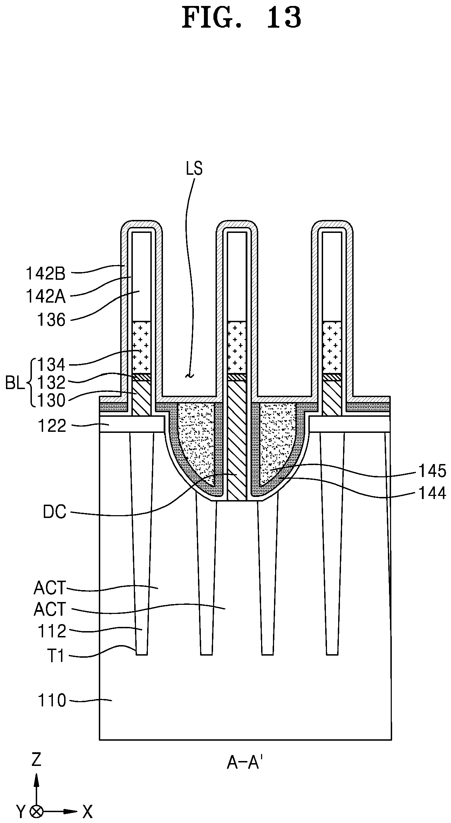

Referring to FIG. 13, a second spacer layer 142B conformally covering an exposed surface of a resultant product of FIG. 12 is formed. The second spacer layer 142B may be formed to cover upper surfaces of the first spacer layer 142A, the first oxide film layer 144, and the buried insulating layer 145. The second spacer layer 142B may be continuously and evenly deposited to a thickness of less than 10 Å (e.g., the thickness may be between 5Å and 10Å, or other amounts less than 5Å). In some embodiments, the second spacer layer 142B may be deposited by using a MOCVD method, a MOVPE method, a CVD method, a LPCVD method, an ALD method, IBSD method, an MBE method, a PA-MBE method, etc.

According to an embodiment, an operation of forming the first oxide film layer 144 and the buried insulating layer 145 is included between operations of forming the first spacer layer 142A and the second spacer layer 142B, and thus, the second spacer layer 142B may not be formed on the inner wall of the direct contact hole DCH. The portion of the spacer structure 140 formed on the inner wall of the direct contact hole DCH may not include the second spacer layer 142B but may include the first spacer layer 142A.

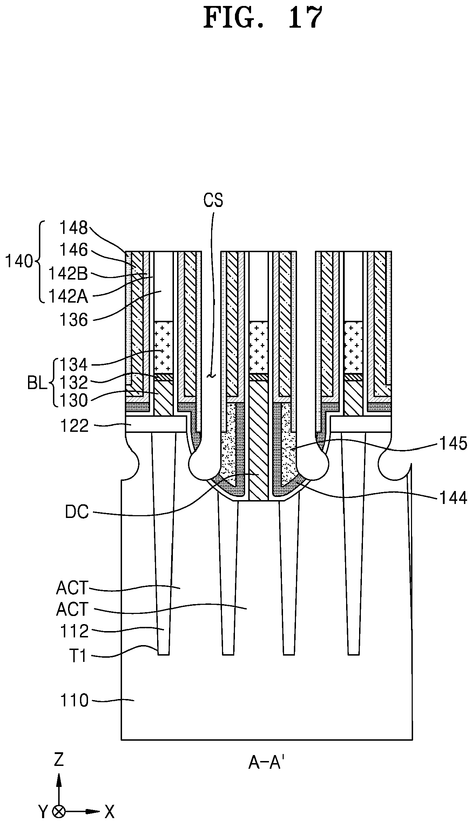

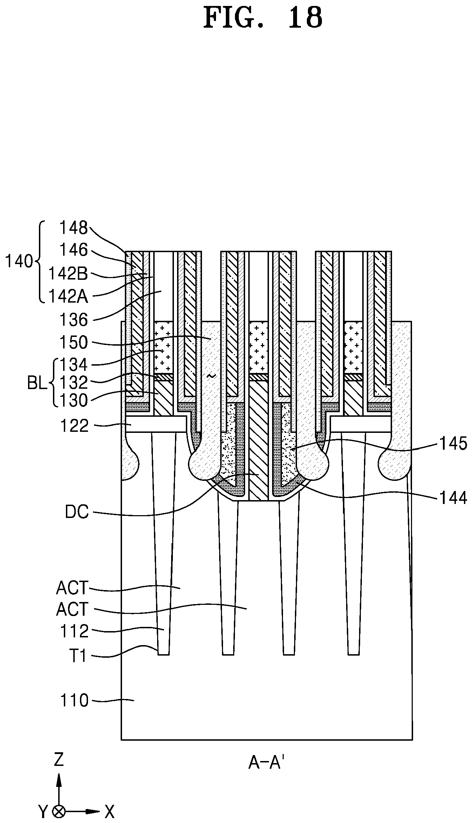

Because the second spacer layer 142B is not formed on the inner wall of the direct contact hole DCH, when forming a plurality of recess spaces R1 and forming a contact plug 150 filling the plurality of recess spaces R1 which will be described below with reference to FIGS. 17 and 18, it is possible to prevent the active region ACT of the substrate 110 from not being exposed. For example, due to a thickness of the spacer structure 140, a problem in which the contact plug 150 and the active region ACT are not connected may be prevented.

In addition, because the second spacer layer 142B is formed before forming the second oxide film layer 146, there is an effect of preventing the upper conductive layer 134 of the bit line BL from being oxidized in the operations of forming and etching the second oxide film layer 146, which will be described later.

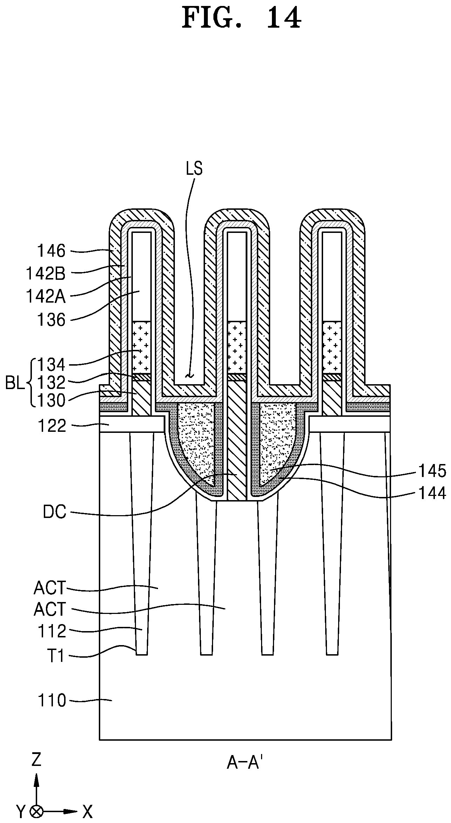

Referring to FIG. 14, the second oxide film layer 146 conformally covering an exposed surface of a resultant product of FIG. 13 may be formed. The second oxide film layer 146 may be conformally disposed on the second spacer layer 142B.

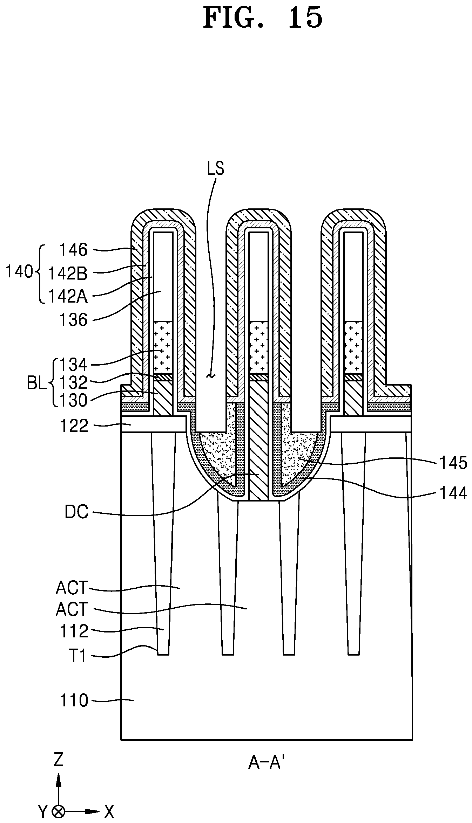

Referring to FIG. 15, a portion of the spacer structure 140 may be etched from a resultant product of FIG. 14. Portions of the second oxide film layer 146, the second spacer layer 142B, the first oxide film layer 144, and the buried insulating layer 145 may be etched in a vertical direction and removed. A certain space may be formed inside the direct contact hole DCH by etching portions of the first oxide film layer 144 and the buried insulating layer 145.

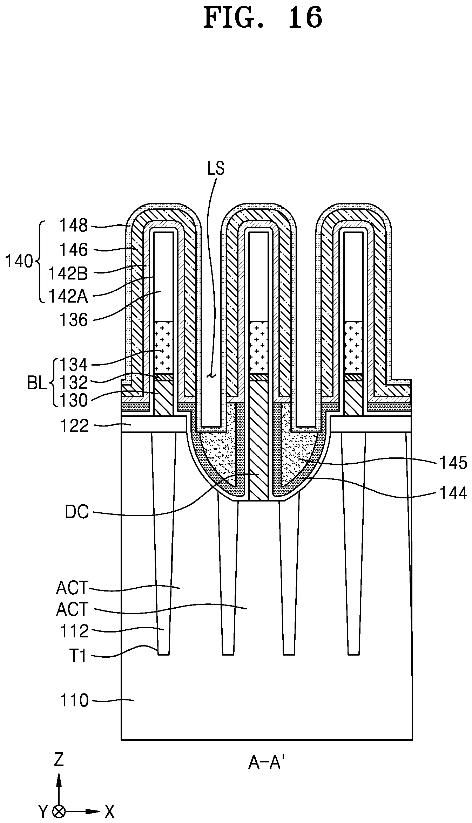

Referring to FIG. 16, an outer spacer layer 148 conformally covering an exposed surface of a resultant product of FIG. 15 is formed. The outer spacer layer 148 may be formed on the second oxide film layer 146 or an exposed certain space of the direct contact hole DCH in FIG. 14. A CVD or ALD process may be used to form the outer spacer layer 148.

Referring to FIG. 17, in a resultant product of FIG. 16, a plurality of insulating fences spaced apart from each other are formed in a line space LS defined by the outer spacer layer 148 between each of the plurality of bit lines BL, and thus, the line space LS may be divided into a plurality of contact spaces CS.

A plurality of recess spaces R1 exposing the active region ACT of the substrate 110 may be formed between each adjacent pair of the plurality of bit lines BL by removing some portions of the structures exposed through the plurality of contact spaces CS. In order to form the plurality of recess spaces R1, an anisotropic etching process or a combination of an anisotropic etching process and an isotropic etching process may be used. For example, the outer spacer layer 148, the second oxide film layer 146, the buried insulating layer 145, and a portion of the substrate 110 thereunder, which are exposed through the plurality of contact spaces CS between each of the plurality of bit lines BL, are anisotropically etched, and a portion of the active region ACT of the substrate 110 exposed as a result of the anisotropically etching may be etched to form the plurality of recess spaces R1. Each of the plurality of recess spaces R1 may communicate with the contact space CS. During the etching process for forming the plurality of recess spaces R1, a portion of each of the second oxide film layer 146 and the buried insulating layer 145 may be consumed in a region adjacent to the upper surface of the substrate 110.

A portion of the active region ACT of the substrate 110, a portion of the first spacer layer 142A, a portion of the second oxide film layer 146, and a portion of the buried insulating layer 158 may be formed through the plurality of recess spaces R1. As described above, according to an embodiment, the second spacer layer 142B is not formed on the inner wall of the direct contact hole DCH, and thus, in a process of forming the recess space R1, a portion of the active region ACT of the substrate 110 may be prevented from not being exposed. The recess spaces R1 may each include a widened bottom portion, for example that forms a bulging curved shape, or bulb shape.

Referring to FIG. 18, a plurality of contact plugs 150 may be formed between each of the plurality of bit lines BL to fill the plurality of recess spaces R1 and a portion of the contact space CS between each of the plurality of bit lines BL. In this case, the plurality of contact plugs 150 may be formed of or may include doped polysilicon, metal, metal silicide, conductive metal nitride, or a combination thereof, but the embodiments are not limited thereto. The contact plugs 150 may have pillar shapes having a widened bottom portion.

Referring back to FIG. 3, a metal silicide layer 172 and a plurality of conductive landing pads LP are sequentially formed on the plurality of contact plugs 150 that are exposed through the plurality of contact spaces CS (refer to FIG. 18).

The contact plug 150 and the metal silicide layer 172 may constitute at least a part of the buried contact BC illustrated in FIG. 1. The plurality of conductive landing pads LP may extend to the top of the insulating capping pattern 136 on the metal silicide layer 172 to vertically overlap with a portion of the plurality of bit lines BL while filling the plurality of contact spaces CS. The plurality of conductive landing pads LP may include a conductive barrier film 174 and a conductive layer 176.

In order to form the plurality of conductive landing pads LP, according to one embodiment, the conductive barrier film 174 and the conductive layer 176 are formed on an entire surface of a resultant product on which the metal silicide film 172 is formed, and then, a mask pattern (not shown) exposing a part of the conductive layer 176 is formed on the conductive layer 176. An upper recess space R2 may be formed by etching the conductive layer 176, the conductive barrier film 174, and the spacer structures 140 therearound using the mask pattern as an etch mask. The mask pattern may include a silicon nitride film but is not limited thereto.

The plurality of conductive landing pads LP may have a plurality of island pattern shapes. Among the plurality of conductive landing pads LP, portions extending in the horizontal direction from the outside of the contact space CS may configure the plurality of conductive landing pads LP illustrated in FIG. 1.

The plurality of conductive landing pads LP may be electrically insulated from each other by filling the upper recess space R2 around the plurality of conductive landing pads LP with the insulating film 180. Afterwards, a plurality of capacitor lower electrodes that are electrically connectable to the plurality of conductive landing pads LP may be formed on the insulating film 180.

Experimental results upon forming integrated circuit devices using a structure as discussed above have shown a reduction of oxidation of certain metal components when a thickness of each of the first and second spacer layers is less than 10 Å.

While the inventive concept has been particularly shown and described with reference to embodiments thereof, it will be understood that various changes in form and details may be made therein without departing from the spirit and scope of the following claims.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

An item, layer, or portion of an item or layer described as extending "lengthwise" in a particular direction has a length in the particular direction and a width perpendicular to that direction, where the length is greater than the width.

Terms such as "same," "equal," "planar," or "coplanar," as used herein when referring to orientation, layout, location, shapes, sizes, compositions, amounts, or other measures do not necessarily mean an exactly identical orientation, layout, location, shape, size, composition, amount, or other measure, but are intended to encompass nearly identical orientation, layout, location, shapes, sizes, compositions, amounts, or other measures within acceptable variations that may occur, for example, due to manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

## Claims

1. An integrated circuit device comprising:
a substrate having a plurality of active regions;
a bit line extending in a first horizontal direction on the substrate;
an insulating capping pattern formed on the bit line and extending along the bit line;
a direct contact disposed in a direct contact hole formed on the substrate and connected between a first active region selected from among the plurality of active regions and the bit line; and
a spacer structure contacting a sidewall of the direct contact and a sidewall of the bit line,
wherein the spacer structure includes:
a first spacer layer extending in a vertical direction on the sidewall of the direct contact and the sidewall of the bit line; and
a second spacer layer covering at least a portion of the first spacer layer and extending in the vertical direction.

2. The integrated circuit device of claim 1, wherein the first spacer layer is formed of h-BN, SiOCN, SiON, SiOC, SiCN, SiC, SiBN, Si₃N₄, a-BN or a combination thereof and the second spacer layer is formed of h-BN, SiOCN, SiON, SiOC, SiCN, SiC, SiBN, Si₃N₄, a-BN or a combination thereof.

3. The integrated circuit device of claim 1 or 2, wherein the first spacer layer has a thickness of less than 10 Å and the second spacer layer has a thickness of less than 10 Å.

4. The integrated circuit device of any one of claims 1 to 3, wherein the second spacer layer is disposed on the first spacer layer to overlap the bit line and a portion of the sidewall of the direct contact and the bit line in a second horizontal direction perpendicular to the first horizontal direction.

5. The integrated circuit device of any one of claims 1 to 4, wherein the first spacer layer is disposed to extend to an inner wall of the direct contact hole along the sidewall of the direct contact and the sidewall of the bit line.

6. The integrated circuit device of any one of claims 1 to 5, wherein a thickness of the spacer structure disposed at an upper end of the sidewall of the direct contact is different from a thickness of the spacer structure disposed at a lower end of the sidewall of the direct contact.

7. The integrated circuit device of any one of claims 1 to 6, wherein the spacer structure further includes:
a second oxide film layer disposed on the second spacer layer; and
an outer spacer layer disposed on the second oxide film layer.

8. The integrated circuit device of any one of claims 1 to 7, further comprising:
a contact plug connected to a second active region adjacent to the first active region among the plurality of active regions and extending in the vertical direction on the substrate;
a buried insulating layer disposed horizontally between a lower end of the contact plug and the first spacer layer; and
a first oxide film layer disposed horizontally between the buried insulating layer and the first spacer layer.

9. The integrated circuit device of any one of claims 1 to 8, wherein the bit line includes a lower conductive layer including a doped polysilicon film and an upper conductive layer including a metal, and
wherein the first spacer layer and the second spacer layer extend in the vertical direction on a sidewall of the upper conductive layer.

10. A method of manufacturing an integrated circuit device, the method comprising:
forming, on a substrate having a plurality of active regions, a bit line, a direct contact hole, and a direct contact connected to a first active region selected from among the plurality of active regions within the direct contact hole;
forming a first spacer layer covering a sidewall of the bit line, a sidewall of the direct contact, and an inner wall of the direct contact hole;
forming a first oxide film layer and a buried insulating layer on the first spacer layer to overlap a lower sidewall of the direct contact and an inner wall of the direct contact hole; and
forming a second spacer layer on the first spacer layer to horizontally overlap a portion of the sidewall of the bit line and a portion of the sidewall of the direct contact.

11. The method of claim 10, wherein the first spacer layer is formed of h-BN, SiOCN, SiON, SiOC, SiCN, SiC, SiBN, Si₃N₄, a-BN or a combination thereof, and the second spacer layer is formed of h-BN, SiOCN, SiON, SiOC, SiCN, SiC, SiBN, Si₃N₄, a-BN or a combination thereof.

12. The method of claim 10 or 11, wherein the first spacer layer has a thickness of less than 10 Å, and the second spacer layer has a thickness of less than 10 Å.

13. The method of any one of claims 10 to 12, wherein the forming of the second spacer layer includes forming the second spacer layer on the first spacer layer such that the second spacer layer does not horizontally overlap the inner wall of the direct contact hole.

14. The method of any one of claims 10 to 13, further comprising:
forming a second oxide film layer on the second spacer layer; and
forming an outer spacer layer on the second oxide film layer.

15. The method of claim 14, further comprising forming a plurality of recess spaces by exposing a second active region adj acent to the first active region by etching a portion of the outer spacer layer, the second oxide film layer, the buried insulating layer, and the substrate thereunder.
